# EUROPEAN PATENT APPLICATION

(11) **EP 3 272 901 A1**
(43) Date of publication of application: **24.01.2018**
(21) Application number: 16179871.5
(22) Date of filing: 18.07.2016
(51) Int. Cl.: C23C 14/56, C23C 14/04, C23C 16/455

(54) **DEPOSITION ARRANGEMENT AND METHOD FOR DEPOSITING**

(71) Applicant: Nederlandse Organisatie voor toegepast- natuurwetenschappelijk onderzoek TNO, 2595 DA 's-Gravenhage (NL)
(72) Inventor: LIFKA, Herbert, 5656 AE Eindhoven (NL)
(74) Representative: V.O.

(57) **Abstract**

A deposition arrangement (1) is provided for depositing a substance (SB) on a substrate surface (ST1) of a substrate (ST). The deposition arrangement comprises a deposition source (20) and a deposition mask (30) that is arranged between the deposition source (20) and the deposition surface. The deposition mask (30) has a first mask surface (38) facing the deposition source and a second mask surface (39) facing the substrate surface (ST1). The deposition mask (30) is provided with a spatial pattern defined by at least one closed area (34) and at least one perforated area (36) defined by a plurality of through holes (37) and wherein a substrate carrier (10) is provided to carry the substrate with its substrate surface (ST1) at distance (D) from the second mask surface (39).

## Description

### BACKGROUND OF THE INVENTION

### Field of the invention

The present application relates to a deposition arrangement.

The present application further relates to a method for depositing

### Related Art

US2011/0065282 pertains to an apparatus for applying a patterned coating to an OLED substrate in a continuous roll-to-roll vapor based deposition process. The apparatus comprises a vapor deposition source, a processing drum, a drive roller, and a shadow mask wherein the shadow mask comprises a mask line feature that selectively prevents deposition of the coating onto the substrate. The mask line features are positioned parallel to the moving direction of the OLED substrate. The shadow mask also comprises one or more beam features, which are positioned perpendicular to the moving direction of the OLED substrate and provide mechanical support to the line features. These beam features serve to prevent the mask line features from deformation related to thermal or mechanical stress. The known apparatus is suitable to deposit mutually spaced coating bands that extend in a longitudinal direction of the substrate. It is a disadvantage that the apparatus is not suitable to deposit features that are bounded in the longitudinal direction.

### SUMMARY OF THE INVENTION

It is an object of the present invention to provide a deposition arrangement and a deposition method that are improved in that they enable a more wide variety of patterns to be deposited while providing for an adequate support of the shadow mask.

According to a first aspect of the invention a deposition arrangement as claimed in claim 1.

According to a second aspect of the invention a deposition method is provided as claimed in claim 17.
Amongst others, the deposition mask in the deposition arrangement and as used in the deposition method is provided with a spatial pattern defined by at least one closed area and at least one perforated area defined by a plurality of through holes. Furthermore, a substrate carrier is provided to carry the substrate with its substrate surface at distance from the second mask surface.
In this deposition arrangement and deposition method it is rendered possible to deposit patterns that could previously not be achieved with a single metal plate as the deposition mask. For example the substrate area that is kept free from deposited substance within the character "e" requires a corresponding closed area in the deposition mask. The area of the substrate surface surrounding this substrate area that should be permeable to the substance to be deposited. This would require however that the closed area of the deposition mask is no longer connected to the remainder of the mask. In the deposition arrangement and deposition method according to the present invention the area permeable for the substance is provided as a perforated area. On the one hand this allows the deposition substance to pass forward to the substrate surface. At the same time it supports the closed areas contained inside. As the substrate carrier is provided to carry the substrate with its substrate surface at distance from the second mask surface, the deposition patterns resulting from the individual through holes in a perforated area overlap mutually, so that the pattern of the individual through holes is not visible (or to a limited extent) in the pattern formed by the substance deposited on the substrate surface.

As the substrate carrier carries the substrate with its substrate surface at distance from the second mask surface, it is achieved that the substance is deposited according to a spatial pattern that corresponds to the spatial pattern defined by the at least one closed area and at least one perforated area of the deposition mask. I.e. the at least one closed area corresponds to an at least a first area on the first substrate surface that is isomorphic with the at least one closed area of the deposition mask and the at least one perforated area corresponds to an at least a second area on the first substrate surface that is isomorphic with the at least one perforated area of the deposition mask.
Therein the at least a first area is substantially free from deposited substance and the at least a second area is provided with a layer of the substance. Due to the fact that substrate carrier carries the substrate with its first substrate surface at distance from the second mask surface, it is achieved that the deposited layer in the at least a second area is substantially homogeneous. A substantially homogeneous layer is understood to be a layer wherein the thickness variations are less substantially less that the average variation of the thickness of the deposited layer. More in particular the difference between the smallest and the largest thickness is less than 50% of the average thickness. Preferably the difference between the smallest and the largest thickness is less than 20% of the average thickness, or even less than 10% of the average thickness.

In an embodiment the deposition mask is provided with a curve shaped form and the substrate carrier carries the substrate with its substrate surface conformally to the second mask surface. Therewith the deposition mask can have an increased structural integrity.

In particular, the deposition mask may be provided as a cylindrical body and the deposition source may be arranged inside the cylindrical body. This allows for a very efficient implementation in a roll to roll arrangement. The roll to roll arrangement in this implementation may for example comprises an actuator for rotating the cylindrical body at an angular velocity, and the transport facility may be arranged to transport the substrate with its substrate surface along a cylindrical trajectory in an at least substantially coaxial manner with respect to the second mask surface wherein the substrate when being transported along said cylindrical trajectory moves with the same angular velocity along the deposition surface. In this embodiment a continuous deposition process is enabled.

In an embodiment the substrate carrier is formed by a pair of support rolls that are arranged at respective lateral sides of the deposition mask, which support rolls have an outer diameter greater than an outer diameter of the deposition mask. In most cases this suffices to properly align and position the substrate with the deposition mask. If desired, the support rolls may be combined with complementary support means, such as complementary support rolls or complementary support belts.

### BRIEF DESCRIPTION OF THE DRAWINGS

These and other aspects are described in more detail with reference to the drawing. Therein:
FIG. 1, 1A, 1B schematically show embodiments of a deposition arrangement according to the first aspect. Therein FIG. 1 shows an overview of an embodiment,
FIG. 1A shows a detail of this embodiment and FIG. 1B shows a cross-section according to IB-IB in FIG. 1A,
FIG. 2A shows a deposition mask in an embodiment of the deposition arrangement in more detail, FIG. 2B is a cross-section according to IIB-IIB in FIG. 2A, and FIG. 2C illustrates alternatives,
FIG. 3A, 3B illustrate experimental results obtained with an embodiment of the arrangement according to the first aspect,
FIG. 4A-4C illustrate a further embodiment. Therein FIG. 4A is a schematic view of various components in this arrangement, FIG. 4B is a top view according to IVB in FIG. 4A, and FIG. 4C is a bottom view according to IVC in FIG. 4A,
FIG. 5A-5C illustrate still further embodiments. Therein FIG. 5A is a schematic view of various components in this arrangement, FIG. 5B is a top view according to VB in FIG. 5A, and FIG. 5C is a top view according to VC in FIG. 5A of a different version of this stil further embodiment,
FIG. 6A-6C illustrate again still further embodiments. Therein FIG. 6A is a schematic view of various components in this arrangement, FIG. 6B is a step-wise cross-section according to VIB-VIB in FIG. 6A, and FIG. 6C is a corresponding step-wise cross-section according to VIC-VIC in FIG. 5A of a different version of the embodiment of FIG. 6A,
FIG. 7 illustrates a variation for the embodiment of FIG. 5B,
FIG. 8A and 8B show a still further embodiment of a deposition arrangement according to the first aspect. Therein FIG. 8B shows a cross-section according to VIIIB-VIIIB in FIG. 8A.

### DETAILED DESCRIPTION OF EMBODIMENTS

Like reference symbols in the various drawings indicate like elements unless otherwise indicated.

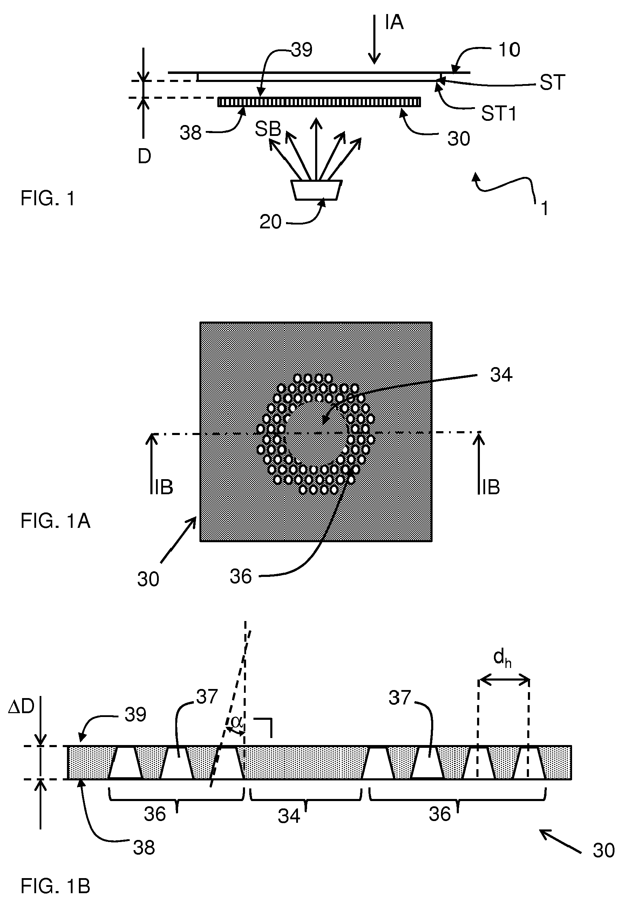

FIG. 1 schematically shows a deposition arrangement 1 for depositing a substance SB on a substrate surface ST1 of a substrate ST. The deposition arrangement comprises a deposition source 20, and a deposition mask 30. The latter is shown in more detail in FIGs. 1A and 1B. Therein FIG. 1A shows a top-view of the deposition mask 30 according to IA in FIG. 1 and FIG. 1B shows a cross-section of the deposition mask according to IB-IB in FIG. 1A. The deposition mask 30 is arranged between the deposition source 20 and the deposition surface ST1 of the substrate ST. The deposition mask 30 has a first mask surface 38 facing the deposition source 20 and a second mask surface 39 facing the substrate surface ST1. As can best be seen in FIG. 1A and FIG. 1B, the deposition mask 30 is provided with a spatial pattern defined by at least one closed area 34 and at least one perforated area 36 defined by a plurality of through holes 37. The substrate carrier 10 is provided to carry the substrate with its substrate surface ST1 at distance from the second mask surface 39.

In an embodiment the deposition mask 30 has a thickness ΔD in a range of about 2 micron to about 500 micron. It is expected that a thickness ΔD that is substantially smaller than 2 micron, e.g. 1 micron, or 0.5 micron, will result in an insufficient rigidity of the deposition mask. In case the thickness ΔD is substantially larger than 500 micron, e.g. 1 mm or 2 mm, would have the effect that a relatively large amount of the evaporated substance is deposited on the walls of the through holes 37.

Preferably the thickness ΔD of the deposition mask 30 is in the same order of magnitude as the diameter of the through holes. For example the thickness may be in a range of 0.2 to 5 times a diameter of the through holes.

In an embodiment the through holes 37 have a diameter in the range between 10 and 100 micron. Accordingly, a deposition mask having through holes with a diameter in the lower range preferably have a thickness in the range of 2 to 100 micron, whereas a deposition mask having its through holes with a diameter in the higher range preferably have a thickness in the range of 20 to 500 micron.

In some applications the through holes 37 may be tapered. For example, the through holes may taper outwards with a direction α towards the deposition source 20 as illustrated in FIG. 1B, wherein the angle α is in a range of 0 to 70 degrees with respect to the normal of the first (or second) mask surface. For practical purposes, regarding manufacturability the angle will typically be selected in a range of 0 to 45 degrees. Alternatively, the through holes may taper outwards with a direction α away from the deposition source, possibly with the angle α in a range of 0 to 70 degrees with respect to the normal of the first (or second) mask surface and for practical purposes, such as regarding manufacturability preferably in a range of 0 to 45 degrees.

The permeability is defined as the fraction occupied by through holes in the perforated area. A permeability in the range of 10% to about 50% has been found most suitable. In case the permeability is substantially less than 10%, e.g. 5% in practice an insufficiently homogeneous deposition is achieved. If the permeability is substantially greater than 50%, e.g. more than 70% the structural integrity of the deposition mask 30 is at stake. In most practical implementations the permeability may be in a range of 15 to 30%, e.g. in the range of 20 to 25%, e.g. 21%. In case the through holes are tapered, the fraction occupied by the through holes is larger on the side of the deposition mask where the through holes are tapered outward. In that case the permeability on the side where the through holes are tapered outward should preferably meet an upper boundary as indicated here for the permeability, e.g. 50%, 30%, or 25%. The permeability on the opposite side of the deposition mask should preferably meet the lower boundary, e.g. 10, 20 or 30%.

In most circumstances the substrate carrier 10 may carry the substrate ST with its surface ST1 at a distance D from the second mask surface 39 such that the distance is in a range of 0.5 to 5 times an average distance dₕ between subsequent through holes. In some circumstances, the distance D may be larger. For example if a sharp transition between features in the deposition pattern on the substrate surface ST1 is not required, or if a smooth transition is desired, the distance D may be even 10 or 20 times the average distance dₕ. This may also be the case if the thickness ΔD of the deposition mask is relatively large as compared to the diameter of the through holes, e.g. if the thickness ΔD of the deposition mask is more than 5x a diameter of the through holes. In other cases the distance D may be smaller than the minimum indicated above. For example if the deposition source 20 has a relatively large area, the distance D may be somewhat smaller, e.g. 0.2 times an average distance dₕ between subsequent through holes.

As used herein, the term "substrate" has its usual meaning in materials science as an object comprising a surface on which processing is conducted, in this case layer deposition. In this context, for example the production of flexible electronics, the substrate typically comprises a foil. The term "foil" refers to a sheet comprising one or more layers of material. There can be structures on the foil on which the mask might be aligned too. The foil is flexible such that it can be used in a roll-to-roll (R2R) manufacturing process. For such purpose, a foil may be considered flexible if it can be rolled or bent over a radius of curvature of 50 cm or less, e.g. 12 cm,. Alternatively, or in conjunction a foil may be considered flexible if it has a flexural rigidity smaller than 500 Pa·m^³. Materials suitable for as the foil, or as a layer for the foil are for example polymers, such as PET, PEN or PI. Also thin glass can be a suitable substrate material. Alternatively, metals may be used for this purpose, such as aluminum, steel or copper. The foil may for example have a thickness in the range of 1 micron to 1 mm depending on the required strength and flexibility. For other purpose also more rigid substrates may be considered, e.g. glass plates. Experiments

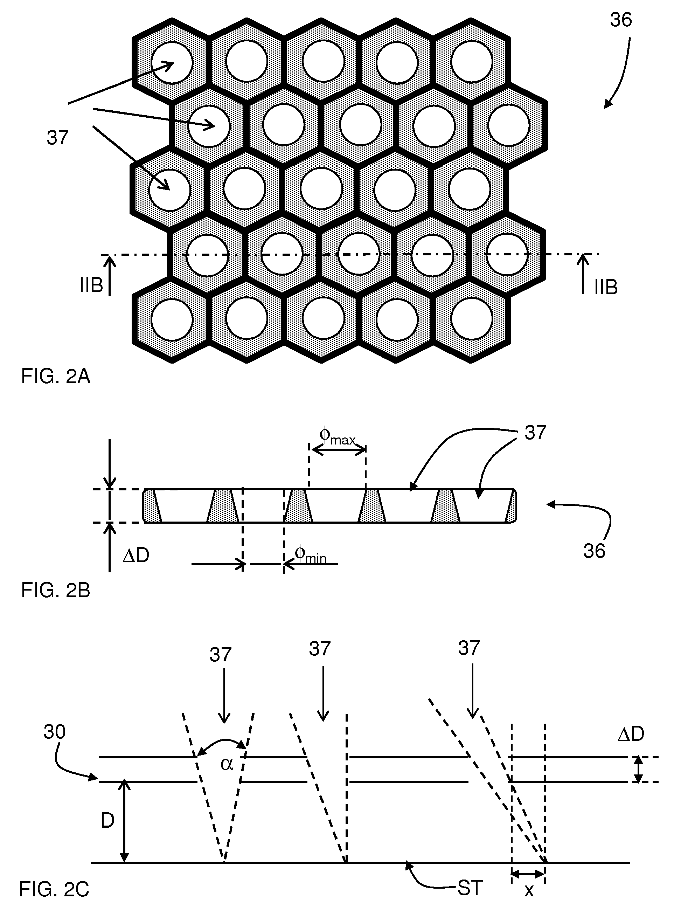

were conducted with a deposition mask with a spatial pattern having closed areas 34 and perforated areas 36. The perforated areas are defined by a plurality of through holes 37. The perforated areas 36 define the areas of the substrate surface ST1 to be provided with a substantially continuous layer of the deposited substance and the closed areas define the areas of the substrate surface ST1 to remain free from the substance. A portion of a perforated area 36 of the deposition mask 30 is illustrated in FIG. 2A - 2B. FIG. 2C illustrates various alternatives. Therein FIG. 2A is a top-view of a perforated area of a deposition mask 30 and FIG. 2B shows a cross-section according to IIB-IIB in FIG. 2A.
The deposition mask as used here is a foil of stainless steel having a thickness of 60 micron that is perforated with through holes 37 having a diameter φₘᵢₙ of 40 micron and spaced at a distance of about 100 micron along a hexagonal grid. The presence of the through holes provides for a permeability of 21%. As can best be seen in FIG. 2B, the through-holes 37 taper outward with an angle of about 20 degrees. However, alternatively, as illustrated in FIG. 2C, the through holes 37 may taper in the opposite direction or be cylindrical. This may be dependent on the nature of the deposition source 20. If the deposition source 20 is a point source, an outward tapering of the through holes 37 in the direction of the substrate ST may be preferred.
The deposition mask having the perforated area 36 as shown in FIG. 2A-2B was arranged at a distance of D=of about 200 micron from a substrate surface of PET foil. Using this deposition mask, aluminum was deposited with custom thermal physical vapor deposition (PVD) device having a capacity of 1nm/min Al. Also other deposition technologies are suitable such as other physical vapor deposition technologies e.g. ebeam-PVD, chemical vapor deposition (CVD) technologies and sputter technologies.

By way of example a first spatial pattern was applied in the form of a set of lines having a stepwise diminishing with. The first line of this pattern has a width of 1000 micron, the second one a width of 500 micron, the third one of 200 micron and so on. According the perforated area 36 in the first line has about 10 neighboring holes in the direction of the width of the line, the second one about 5 and so on.

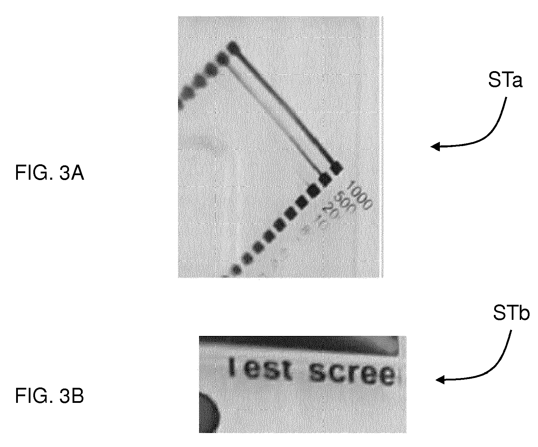

The processed substrate STa, so obtained is shown in FIG. 3A. It can be seen that the line having a width of 1000 micron is clearly visible. Also the line having the width of 500 micron is still visible. Accordingly, good deposition results can be obtained for pattern elements having a minimum size of about 5 or more times a spacing of neighboring through holes.

FIG. 3B shows an other example where the deposition arrangement as described with reference to FIG. 1,1A, 1B, with the deposition mask of FIG. 2A, 2B, was used to deposit aluminum as a pattern of characters on the substrate STb.

The deposition arrangement with this deposition mask makes it possible to deposit patterns that could previously not be achieved with a single metal plate as the deposition mask. For example the substrate area that is kept free from deposited substance within the character "e" requires a corresponding closed area in the deposition mask. The area of the substrate surface surrounding this substrate area that should be permeable to the substance to be deposited. This would require however that the closed area of the deposition mask is no longer connected to the remainder of the mask. In the deposition arrangement according to the present invention the area permeable for the substance is provided as a perforated area, that on the one hand allows the deposition substance pass forward to the substrate surface, and that on the other hand supports the closed areas contained inside.

In embodiments the deposition mask may comprise fully open areas in addition to closed areas and perforated areas. For example for deposition of the pattern illustrated in FIG. 3B, the pattern on the deposition mask that corresponds to the character "t" may be formed as a fully open area.

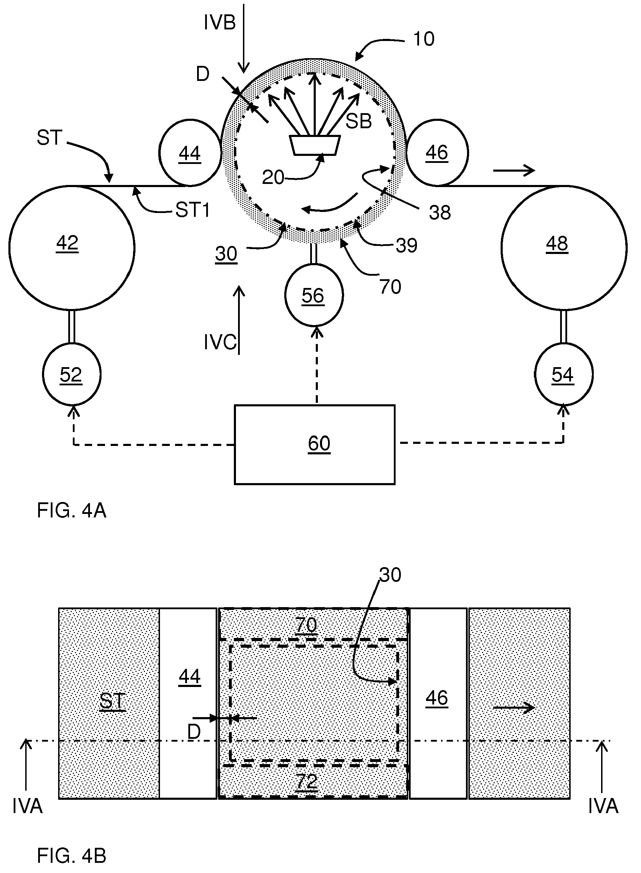

FIG. 4A -4C shows an embodiment of an arrangement of the present invention that allows for a roll2roll manufacturing of products on foil. The foil may for example be a PET or PEN foil, e.g. having thickness in the range of 100 to 200 micron.

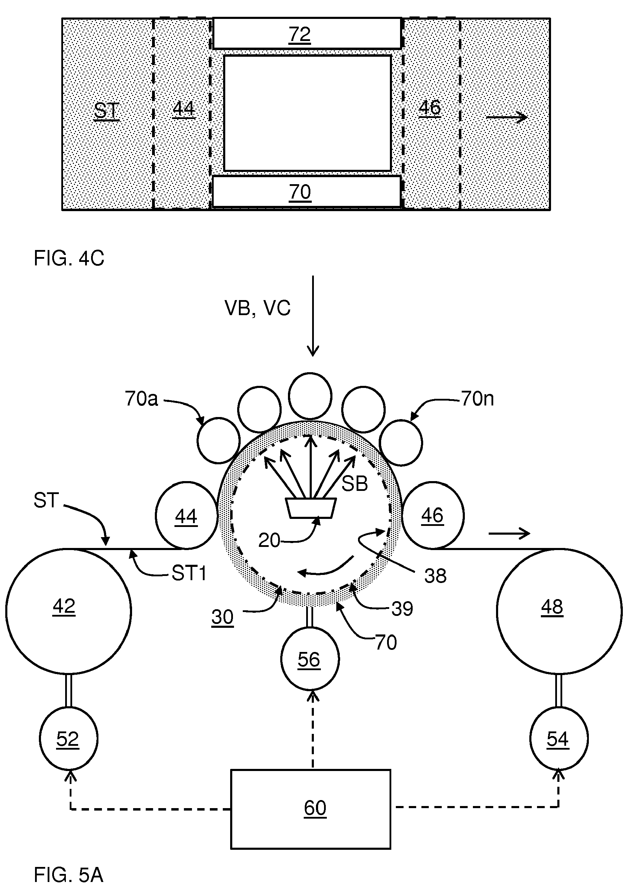

A schematic overview of the arrangement is presented in FIG. 4A. FIG. 4B is a top-view of the arrangement according to IVB in FIG. 4A. FIG. 4B also shows the point of view (IVA), from which parts (e.g. ST, 44, 46, 70)) of the arrangement that are visible in FIG. 4B are visible in FIG. 4A. FIG. 4C is a top-view of the arrangement of FIG. 4A according to IVC. For clarity, the views FIG. 4B and FIG. 4C only show substrate ST, deposition mask 30, guide rolls 44, 46 and support rolls 70, 72.
The deposition arrangement shown in FIG. 4A-4C comprises a substrate transport facility 42, 48, 52, 54 for transporting the substrate ST along the substrate carrier 10. In the embodiment shown, the substrate transport facility includes an unwinding roll 42, a first guide roll 44, a second guide roll 46 and a winding roll 48. Reference numerals 52, and 54 indicate actuators that respectively induce a rotation of the unwinding roll 42 and the winding roll 44. It will be appreciated that the deposition arrangement of FIG. 4A-4C may be combined with other, similar deposition arrangements or deposition arrangements of a different type that are arranged in the path from the unwinding roll 42 to the winding roll 48.

In the embodiment of FIG. 4A-4C, the deposition mask 30 is provided with a curve shaped form. The substrate carrier is formed by a pair of support rolls 70, 72 arranged at respective lateral sides of the deposition mask. The pair of support rolls carry the substrate ST with its substrate surface ST1 conformal to the second mask surface 39 at a distance D to said second mask surface. The support rolls may actively or passively rotate at a rotational speed such that their circumference has a speed corresponding to the substrate ST carried therewith.
To keep the substrate surface ST1 conformal to the second mask surface 39 at a distance D to the second mask surface the support rolls 70, 72 have an outer diameter that is 2D larger than the outer diameter of the deposition mask. One or both of the support rolls may have a central opening, e.g. be formed as a hollow cylinder and have an outer bearing, so that interior parts of the arrangement, such as the deposition source are easily accessible for service purposes for example. The arrangement of the deposition mask 30 as a curved shape further increases mechanical stability in addition to the mechanical stability that is provided by the presence of perforated areas as a replacement for fully open areas in the deposition mask. In particular a very stable mechanic structures is obtained in that the deposition mask 30 is provided as a cylindrical body. The deposition source 20 is arranged inside the cylindrical body.

The embodiment of the deposition arrangement of FIG. 4A comprises an actuator 56 for rotating the cylindrical body at an angular velocity. All actuators 52, 54, 56 are controlled by a controller 60. The controller 60 may further receive input from various sensors and/or detectors, such as one or more tension sensors for measuring a tension in the substrate, a speed sensor for measuring a transportation speed of the substrate, an speed sensor for measuring a rotation speed of the deposition mask 30, a distance sensor for sensing a distance between the outer surface 39 of the deposition mask 30 and the substrate surface ST1. The transport facility 42, 48, 52, 54 is arranged to transport the substrate ST with its substrate surface ST1 along a cylindrical trajectory in an at least substantially coaxial manner with respect to the second mask surface 39. Therewith the substrate ST when being transported along the cylindrical trajectory moves with the same angular velocity along the deposition surface. In this case the cylindrical trajectory is defined by the outer surface of the support rolls 70, 72 that guide the substrate.

For a relatively thin substrate the support by only the support rolls 70, 72 may be insufficient to maintain the substrate properly aligned with the deposition mask 30.

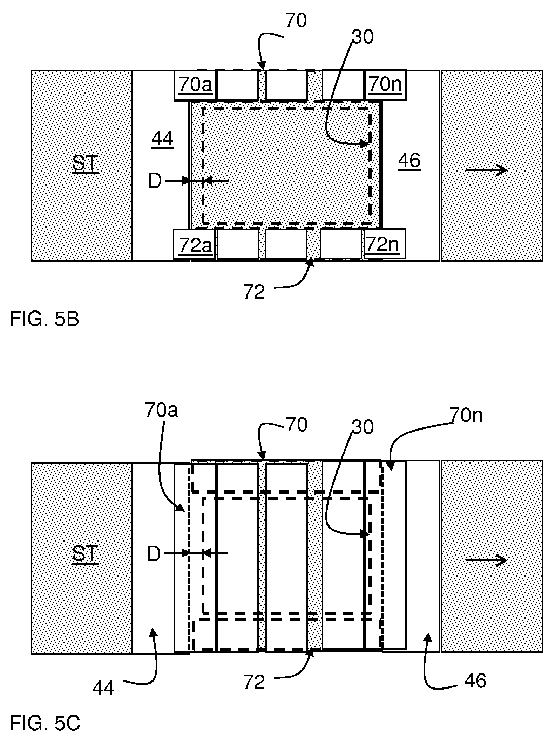

FIG. 5A-5C shows versions of an alternative embodiment that provide additional support. Parts therein corresponding to those of FIG. 4A-4C have the same reference. FIG. 5B shows a cross-section of one version according to top-view VB. FIG. 5C shows a cross-section of another version according to top-view VC. In the embodiment shown in FIG. 5A-5C the substrate carrier comprises in addition to the support rolls 70, 72 complementary support rolls 70a,..70n. In the embodiment shown in FIG. 5B each of the support rolls has respective complementary support rolls. I.e. support roll 70 has complementary support rolls 70a,...,70n and support roll 72 has complementary support rolls 72a,...,72n. The complementary support rolls 70a,...,70n and 72a,...,72n provide further support in that the substrate ST is guided on one of its lateral sides between the support roll 70 and the complementary support rolls 70a,...,70n, while on its opposite lateral side it is guided between support roll 72 and its associated complementary support rolls 72a,...,72n. The complementary support rolls may press a lateral side of the substrate ST towards the support roll with which they are associated. In the embodiment shown in FIG. 5C, the support rolls 70, 72 share a set of complementary support rolls 70a, .. 70n. I.e. the complementary support rolls 70a, .., 70n extend over the full width of the substrate ST.

In an embodiment, alternatively or additionally tenter frame technology may be used. Therein two closely spaced endless chains with substrate holding clips are provided to keep the substrate on a controlled distance from the deposition mask. The substrate holding clips may cooperate with perforations in the substrate. Examples thereof are described in US 650385, US 2584553 and US 4403379.

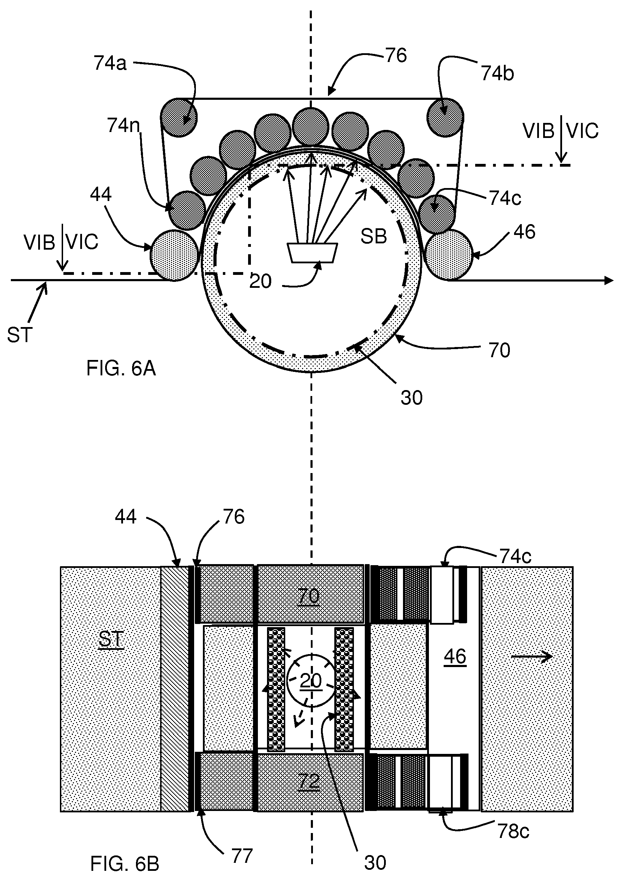

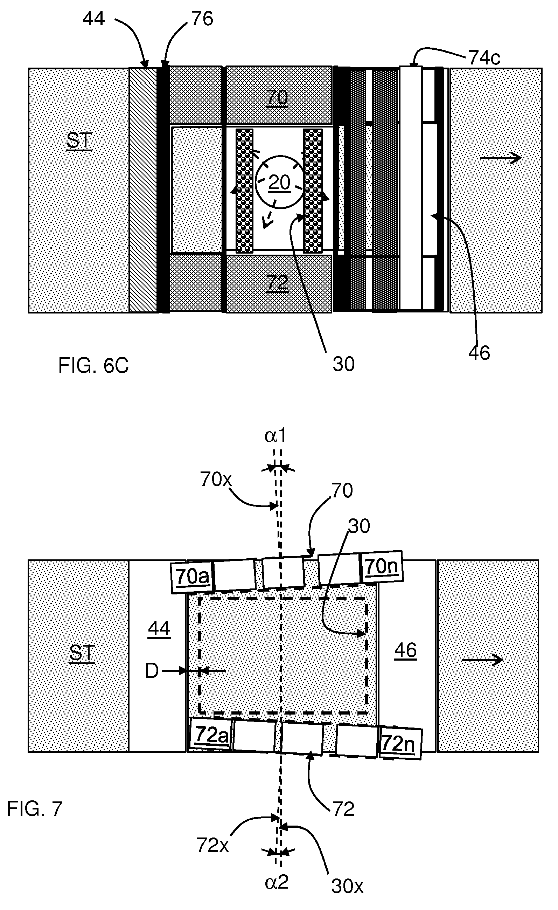

A still further embodiment is shown in FIG. 6A-6C. FIG. 6B shows a stepped cross-section of one version according to VIB-VIB in FIG. 6A. FIG. 6C shows a stepped cross-section of another version according to top-view VIC-VIC. In the embodiment shown in FIG. 6A-6C the substrate carrier comprises in addition to the support rolls 70, 72 a respective complementary support belt (FIG. 6B) or a shared complementary support belt (FIG. 6C).
In the embodiment of FIG. 6B each of the support rolls 70, 72 has a respective complementary support belt 76, 77. As can best be seen in FIG. 6A complementary support belt 76 forms an endless loop around a set of support belt guide rolls 74a, 74b, 74c,..74n. Likewise support belt 77 is formed as an endless loop around a set of support belt guide rolls, of which one support belt guide roll 78c can be seen in FIG. 6B. In operation of the arrangement, the substrate ST is guided on one of its lateral sides between support roll 70 and its associated complementary support belt 76. On its opposite lateral side the substrate ST is guided between support roll 72 and its associated complementary support belt 77. Therewith a complementary support belt 76, 77 may exert a pressure on the associated side of the substrate in the direction of the associated support roll. Therewith the substrate ST is clamped on one lateral side between support roll 70 and associated complementary support belt 76, and on the other lateral side between support roll 72 and associated complementary support belt 77. The pressure exerted by complementary support belt 76 and may be induced with support belt guide rolls 74c etc. and 78c etc. respectively.
In the version of FIG. 6C, the support rolls 70, 72 cooperate with a shared complementary support belt 76 that extends over the full width of the substrate ST. As can best be seen in FIG. 6A complementary support belt 76 forms an endless loop around a set of support belt guide rolls 74a, 74b, 74c,..74n, which in this case typically also extend over the full width of the substrate ST. Also in the embodiment of FIG. 6B, it may be contemplated to guide the complementary support belts 76, 77 around a shared set of support belt guide rolls 74a, 74b, 74c,..74n, which in this case typically also extend over the full width of the substrate ST. The complementary support belts 76,77 may for example be formed of an elastic resilient material, such as spring steel, but also other materials may be suitable, such as copper alloys with nickel, tin and zinc or polymers. Dependent on the material used, the thickness of the endless belt may be in the range of 0.01 to 0.5 mm, e.g. from 0.05 to 0.1 mm.

FIG. 7 shows an alternative version of the embodiment of FIG. 5B. In this embodiment the support rolls 70, 72 are have a rotation axis with a direction deviating from the rotation axis of the deposition mask 30. The deviation of the support roll 70 on the left-hand lateral side of the substrate when facing in the transport direction is anti-clockwise. The deviation of the support roll 72 on the right-hand lateral side of the substrate when facing in the transport direction is clockwise.

In particular it can be seen in the top view of FIG. 7 that the support roll 70 has a rotation axis 70x that deviates with an angle α1 in an anti-clockwise direction with the rotation axis of the deposition mask 30. Support roll 72 has a rotation axis 72x that deviates with an angle α2 in an clockwise direction with the rotation axis of the deposition mask 30. Typically the angles α1, α2 have the same magnitude, so a to avoid a lateral displacement of the substrate ST.
The complementary support rolls 70a,...,70n are preferably aligned with their associated support roll 70. Likewise the complementary support rolls 72a,...,72n are preferably aligned with their associated support roll 72. In the arrangement of FIG. 7, the substrate ST is clamped at its lateral edges between a support roll and its associated complementary support rolls. Due to the deviation of the rotation angles as specified here, a lateral tension is exerted on the substrate ST. This may even further improve the alignment of the surface ST1 of the substrate ST with the outer surface 39 of the deposition mask 30. It is noted that for purpose of illustration the deviations have a magnitude (3 degrees) that is clearly visible. In practice the magnitude may be substantially smaller to achieve that merely a mild tension is exerted that achieves a proper alignment of the substrate while avoiding that it is damaged. Alternatively it may be contemplated to have a larger deviation, while allowing the substrate ST to slip between a support roll and its opposing complementary support rolls.

It is noted that the same principle is applicable to the embodiment shown in FIG. 6A, 6B. Also here the support rolls 70, 72 may be arranged with a deviating rotation angle as specified above. In this case the complementary support belt 76 can be aligned with the support roll 70, so that its trajectory deviates with an angle α1 in the counter clock wise direction with the trajectory of the substrate ST. Analogously, In this case the complementary support belt 77 can be aligned with the support roll 72, so that its trajectory deviates with an angle α1 in the clock wise direction with the trajectory of the substrate.

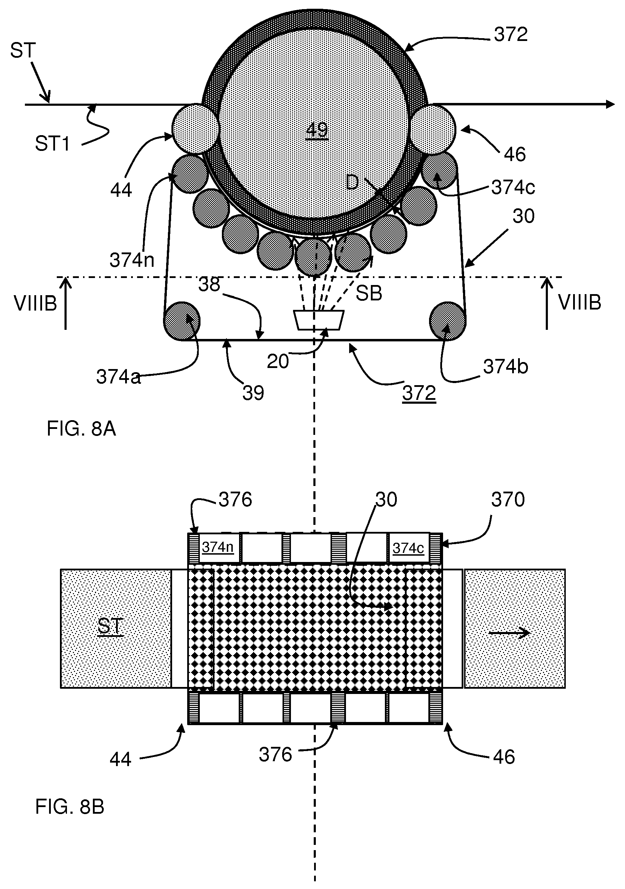

FIG. 8A, 8B show a further deposition arrangement according to the present invention. Therein FIG.8B shows a cross-section according to VIIIB-VIIIB in FIG. 8A. In this embodiment the deposition mask 30 is formed as a central zone in an endless belt 370. The endless belt 370 may for example be formed of a elastic resilient material, such as spring steel, but also other materials may be suitable, such as copper alloys with nickel, tin and zinc or polymers. Dependent on the material used, the thickness of the endless belt may be in the range of 0.01 to 0.5 mm, e.g. from 0.05 to 0.1 mm.
In this arrangement the deposition source 20 is arranged inside the loop formed by the endless belt 370. The endless belt 370 is guided on mutually opposite lateral sides by a respective belt guide roll 372 and complementary belt guide rolls 374a, 374b, 374c, ...,374n. The substrate ST is carried by a substrate carrier roll 49 at a predetermined distance D from the second surface 39 of the deposition mask. The guide roll 372 and complementary belt guide rolls 374a, 374b, 374c, ...,374n, leave free the deposition mask 30 in the central zone of the endless belt 370, so that substance SB can reach the first surface ST1 of the substrate via the deposition mask. The deposition mask 30 in the deposition arrangement is provided with a spatial pattern defined by at least one closed area and at least one perforated area defined by a plurality of through holes. As the substrate carrier roll 49 carries the substrate with its substrate surface at distance from the second mask surface 39, it is achieved that the substance SB is deposited according to a spatial pattern that corresponds to the spatial pattern defined by the at least one closed area and at least one perforated area of the deposition mask. I.e. the at least one closed area corresponds to an at least a first area on the first substrate surface that is isomorphic with the at least one closed area of the deposition mask. The at least one perforated area corresponds to an at least a second area on the first substrate surface that is isomorphic with the at least one perforated area of the deposition mask.
Therein the at least a first area is substantially free from deposited substance and the at least a second area is provided with a layer of the substance. Due to the fact that substrate carrier roll 49 carries the substrate ST with its first substrate surface ST1 at distance D from the second mask surface 39, it is achieved that the deposited layer in the at least a second area is substantially homogeneous. A substantially homogeneous layer is understood to be a layer wherein the thickness variations are less substantially less that the average variation of the thickness of the deposited layer. More in particular the difference between the smallest and the largest thickness is less than 50% of the average thickness. Preferably the difference between the smallest and the largest thickness is less than 20% of the average thickness, or even less than 10% of the average thickness.
It is an advantage of this embodiment that the mechanical load of the substrate ST during processing is minimal. This is of particular advantage for very thin substrates, e.g. having a thickness in the range of 1 to 10 micron.

## Claims

1. Deposition arrangement (1) for depositing a substance (SB) on a substrate surface (ST1) of a substrate (ST), the deposition arrangement comprising a deposition source (20), and a deposition mask (30) arranged between the deposition source (20) and said deposition surface, the deposition mask (30) having a first mask surface (38) facing the deposition source and a second mask surface (39) facing the substrate surface (ST1), wherein the deposition mask (30) is provided with a spatial pattern defined by at least one closed area (34) and at least one perforated area (36) defined by a plurality of through holes (37) and wherein a substrate carrier (10, 70, 72) is provided to carry the substrate with its substrate surface (ST1) at distance (D) from the second mask surface (39).

2. Deposition arrangement according to claim 1, comprises a substrate transport facility (42, 48, 52, 54) for transporting the substrate (ST) along said substrate carrier (10, 70,72).

3. Deposition arrangement according to claim 2, wherein the deposition mask (30) is provided with a curve shaped form and wherein the substrate carrier (10) carries the substrate (ST) with its substrate surface (ST1) conformal to said second mask surface (39).

4. Deposition arrangement according to claim 3, wherein the deposition mask (30) is provided as a cylindrical body and wherein the deposition source (20) is arranged inside the cylindrical body.

5. Deposition arrangement according to claim 4, wherein the deposition arrangement comprises an actuator (56) for rotating the cylindrical body at an angular velocity, and wherein the transport facility (42, 48, 52, 54) is arranged to transport the substrate (ST) with its substrate surface (ST1) along a cylindrical trajectory in an at least substantially coaxial manner with respect to the second mask surface (39), wherein the substrate when being transported along said cylindrical trajectory moves with the same angular velocity along the deposition surface.

6. Deposition arrangement according to any one of the claims 3-5, wherein the substrate carrier is formed by a pair of support rolls (70, 72) arranged at respective lateral sides of the deposition mask, which support rolls have an outer diameter greater than an outer diameter of the deposition mask.

7. Deposition arrangement according to claim 6, wherein the substrate carrier further comprises one, two or more complementary support rolls (70a,...,70n), the substrate (ST) being guided on one of its lateral sides between the support roll (70) and associated complementary support rolls (70a,...,70n).

8. Deposition arrangement according to claim 7, wherein at least one of the one, two or more complementary support rolls (70a,...,70n) exerts a pressure on the substrate (ST) towards the support roll (70).

9. Deposition arrangement according to claim 7 or 8, wherein each of the support rolls (70; 72) has a respective set of one, two or more complementary support rolls (70a,...,70n; 72a,...,72n).

10. Deposition arrangement according to claim 7 or 8, wherein the support rolls (70; 72) share a set of one, two or more complementary support rolls (70a,...,70n).

11. Deposition arrangement according to one of the previous claims, wherein the substrate carrier further comprises a complementary support belt (70a,...,70n), the substrate (ST) being guided on one of its lateral sides between the support roll (70,72) and the associated complementary support belt (76,77).

12. Deposition arrangement according to claim 11, wherein the complementary support belt (76, 77) exerts a pressure on the substrate (ST) towards the support roll (70,72).

13. Deposition arrangement according to claim 11 or 12, wherein each of the support rolls (70; 72) has a respective complementary support belt (76, 77).

14. Deposition arrangement according to claim 11 or 12, wherein the support rolls (70; 72) share a complementary support belt (76).

15. Deposition arrangement according to any one of the claims 7-14, wherein the support rolls (70, 72) have a rotation axis with a direction deviating from the rotation axis of the deposition mask (30), the deviation of the support roll (70) on the left-hand lateral side of the substrate when facing in the transport direction being anti-clockwise and the deviation of the support roll (72) on the right-hand lateral side of the substrate when facing in the transport direction being clockwise.

16. Deposition arrangement according to one of the previous claims, wherein the through holes (37) widen in a direction from the second mask surface (39) to the first mask surface (38).

17. Deposition arrangement according to one of the previous claims, wherein the through holes (37) widen in a direction from the first mask surface (38) to the second mask surface (39).

18. Deposition arrangement according to claim 2, wherein the deposition mask (30) is formed as a central zone in an endless belt (370),and wherein the deposition source (20) is arranged inside a loop formed by the endless belt (370), the endless belt (370) being guided on mutually opposite lateral sides by a respective belt guide roll (372) and complementary belt guide rolls (374a, 374b, 374c, ...,374n), the substrate (ST) being carried by a substrate carrier roll (49) at a predetermined distance D from the second surface (39) of the deposition mask.

19. Method for depositing a substance (SB) on a substrate surface (ST1) of a substrate (ST), the method comprising:
- providing the substance (SB);
- allowing the substance to pass through a deposition mask (30) in a direction from a first mask surface (38) of said deposition mask (30) towards a second mask surface (39) of said deposition mask (30) to be deposited on the substrate surface (ST1) facing the second mask surface (39);
**characterized in that** the deposition mask (30) is provided with a spatial pattern defined by at least one closed area (34) and at least one perforated area (36) defined by a plurality of through holes (37) and
- comprising carrying the substrate with its substrate surface (ST1) at distance from the second mask surface (39).
